# EUROPEAN PATENT APPLICATION

(11) **EP 4 796 493 A1**
(43) Date of publication of application: **26.08.2026**
(21) Application number: 26156878.6
(22) Date of filing: 06.02.2026
(51) Int. Cl.: B81C 1/00

(54) **MEMS DEVICE WITH A CAP AND A SIGNAL PROCESSING CIRCUIT, OF SMALL DIMENSIONS, AND MANUFACTURING PROCESS THEREOF**

(30) Priority: 21.02.2025 IT 202500003408
(71) Applicant: STMicroelectronics International N.V., 1228 Plan-les-Ouates, Geneva (CH)
(72) Inventor: GARAVAGLIA, Matteo, 20864 AGRATE BRIANZA (MB) (IT); OGGIONI, Laura, 20864 AGRATE BRIANZA (MB) (IT); BALDINI, Angelica, 20864 AGRATE BRIANZA (MB) (IT); PALLARO, Mattia, 20864 AGRATE BRIANZA (MB) (IT); CORSO, Lorenzo, 20864 AGRATE BRIANZA (MB) (IT); GATTERE, Gabriele, 20864 AGRATE BRIANZA (MB) (IT)
(74) Representative: Studio Torta S.p.A.

(57) **Abstract**

Microelectromechanical -MEMS- device (35) formed by a first substrate (1'), having a first and a second main face (35A, 1B) and accommodating integrated electrical components (10) and external connection vias (33) extending through the first substrate (1'); a second substrate (2'), having a first and a second main face (2A, 25B) and accommodating conductive vias (17) extending between the first and second main surfaces of the second substrate, the first main face (25B) of the second substrate (2') coupled to the second main face (1B) of the first substrate (1') and the conductive vias (17) coupled to the external connection vias (33); and a third substrate (3'), having a main face (3A) and accommodating MEMS structures (19), the main face (3A) of the third substrate (3') coupled to the second main face (25B) of the second substrate (2'). The conductive vias (17) and the external connection vias (33) electrically couple the first face (35A) of the first substrate (1') to the MEMS structures (19).

## Description

### Technical Field

The present invention relates to a MEMS device with a cap and a signal processing circuit, of small dimensions, and to the manufacturing process thereof. In particular, the present description refers to an inertial MEMS device including a signal processing circuit implemented as an ASIC (Application Specific Integrated Circuit), to which reference will be made in the following description, without being limited thereto. For example, the MEMS device may be a generic sensor, such as a pressure sensor, an infrared temperature sensor and the like.

### Background

MEMS devices formed by three dice of semiconductor material are known, wherein a first die forms one or more MEMS sensors and is bonded to a second die that integrates a circuit for processing signals provided by the MEMS sensor(s) (ASICs) and a third die is bonded above the first die and forms a cap, to protect the mechanical parts of the MEMS sensor.

Normally, such devices are formed from different wafers that are bonded to each other and to temporary work wafers, so as to allow thinning and reduction of the final thickness of the MEMS device.

For example, a process currently used envisages, after forming the movable structures in a MEMS wafer ("MEMS wafer" or "sensor wafer") and possibly forming cavities in a cap wafer, bonding the MEMS wafer and the cap wafer, bonding to a temporary work wafer, thinning the sensor wafer; removing the temporary work wafer, bonding to an ASIC wafer, and thinning the cap wafer and the ASIC wafer, possibly using a second temporary work wafer.

The process also envisages wire bonding steps for electrically connecting the sensor(s) in the MEMS wafer to the circuit in the ASIC wafer, before or after dicing the composite wafer, so as to form a plurality of devices that may be subject to final processing steps, for example for forming external connections and possibly packaging.

In view of the desire to use such MEMS devices in increasingly smaller portable and/or wearable apparatuses, such as smartphones, smartwatches and the like, it is desired to further reduce their dimensions.

However, this is not simple, despite the thinning operations of the wafers, also due to the space required by the internal connections between the dice (wires) and the external connections (for example "balls" in LGA - Land Grid Array - packages).

Various solutions have been proposed to reduce the total size, for example through the use of internal connections through silicon vias (so-called TSV- Through Silicon Vias), but they allow an insufficient reduction of dimensions.

US 2010/019393 discloses a microelectromechanical device comprising an ASIC unit coupled to a MEMS unit through a cap. The cap accommodates conductive vias coupling the MEMS unit to the ASIC unit.

The aim of the present invention is to provide a device and a manufacturing process that overcome the drawbacks of the prior art.

### Summary

According to the present invention, a MEMS device and a manufacturing process of a MEMS device are provided, as defined in the appended claims.

### Brief Description of the Drawings

For a better understanding of the present invention, some embodiments thereof are now described, purely by way of non-limiting example, with reference to the attached drawings, wherein:
- Figures 1-9 show cross-sections through three wafers of conductive material, separated and then mutually bonded, in successive manufacturing steps;
- Figure 10 is a cross-section of a MEMS device obtainable with the process of Figures 1-9;
- Figure 11 is a cross-section of a composite wafer usable as an alternative to one of the wafers in the process steps according to Figures 1-9;
- Figures 12 and 13 show cross-sections through a composite wafer, in two successive process steps usable as an alternative to Figures 6-7, according to a different embodiment;
- Figure 14 is a cross-section of a wafer of semiconductor material in a variant of the manufacturing step of Figure 1; and
- Figures 15 and 16 show cross-sections through a composite wafer, in successive process steps, using the wafer of Figure 14 and as an alternative to Figure 8.

### Description of Embodiments

The following description refers to the arrangement shown; consequently, expressions such as "above", "below", "upper", "lower", "right", "left" relate to the attached Figures and are not to be construed in a limiting manner.

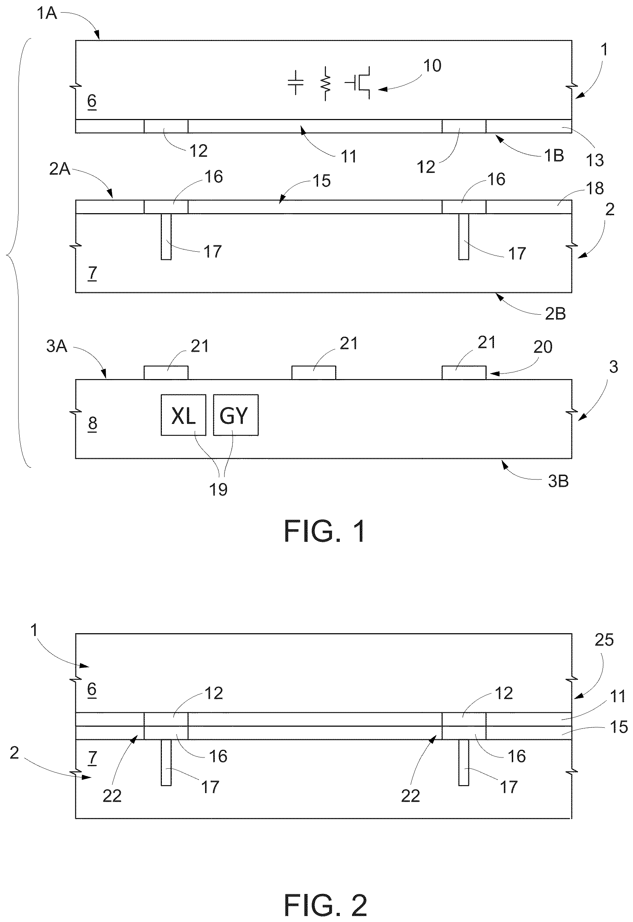

Figure 1 shows a cross-section through three wafers, intended to be bonded to each other and including:
a first wafer 1 integrating electrical circuits, hereinafter also referred to as ASIC wafer 1;
a second wafer 2 having a protective purpose, hereinafter also referred to as cap wafer 2; and
a third wafer 3, integrating MEMS structures, hereinafter also referred to as MEMS wafer 3.

Wafers 1-3 each have a respective first main surface 1A, 2A, 3A and a respective second main surface 1B, 2B, 3B.

Wafers 1-3 have already undergone to processing steps from a respective body (hereinafter also referred to as a first body 6, a second body 7 and a third body 8, respectively) of semiconductor material, such as monocrystalline silicon, of standard thickness, for example 725 µm.

In particular, in Figure 1, ASIC wafer 1 has already undergone to usual semiconductor processing steps including growing, depositing, implanting, annealing, selectively removing, etc., for the integration, in and on the first body 6, of electronic circuits, as schematically represented in Figure 1 by electronic components 10.

Furthermore, at the second main surface 1B of the first wafer 1, a first connection structure 11 has been formed, superimposed on the first body 6. In particular, the first connection structure 11 may include one or more insulating layers and one or more electrical connection layers, for example an RDL layer (redistribution layer), as represented schematically in Figure 1 by a first insulating layer 13 accommodating first intra-wafer connection regions 12, of electrically conductive material, electrically coupled to the electronic components 10.

The first intra-wafer connection regions 12 are formed for example using a damascene technique, by forming cavities in the first insulating layer 13 in the zones where it is desired to form the first intra-wafer connection regions 12, depositing or growing metal material, such as copper, and removing excess metal.

Cap wafer 2 has already been processed so as to form a second connection structure 15, above the second body 7, at the first main surface 2A of the cap wafer 2 which is intended to be bonded to the ASIC wafer 1.

The second connection structure 15 may comprise a single insulating layer (although this is not essential and multiple insulating layers may be formed, for example, deposited), indicated by 18, and second intra-wafer connection regions 16.

The second intra-wafer connection regions 16 may be formed, for example, using a damascene technique (like the first intra-wafer connection regions 12) and are arranged so as to be aligned with the first intra-wafer connection regions 12 of the ASIC wafer 1, after mutual bonding of the cap wafer 2 and the ASIC wafer 1.

The cap wafer 2 also comprises conductive vias 17 extending in the second body 7 from the second intra-wafer connection regions 16, towards the inside, for a height correlated to the final thickness of the cap wafer 2, as discussed in detail below.

The conductive vias 17 are formed (generally before the second connection structure 15) for example as Through Silicon Vias, TSV, insulated from the rest of the cap wafer 2 by respective insulating walls, not shown. The conductive vias 17 may be formed for example by deep etching the silicon of the second body 7, thereby forming holes; forming insulating walls in the holes, for example by thermal oxidation; filling the holes with doped deposited silicon and possibly removing excess oxide and silicon from the surface of the second body 7, in a per se known manner.

Alternatively, the conductive vias 17 may be formed of metal, for example using a damascene process with a copper (PMD, Pre-Metal Deposition, copper) layer, also in this case electrically insulated from the rest of the cap wafer 2.

The MEMS wafer 3 has already been processed so as to form, in the third body 8, desired micro-electro-mechanical structures, for example inertial sensors such as an accelerometer XL and a gyroscope GY, schematically indicated in Figure 1 by 19.

Furthermore, a third connection structure 20 has already been formed on the MEMS wafer 3. The third connection structure 20 overlies the third body 8, at the first main surface 3A of the MEMS wafer 3, intended to be bonded to the cap wafer 2, after its thinning, as described in detail below.

In particular, the third connection structure 20 comprises third intra-wafer connection regions 21 formed on the first main surface 3A of the MEMS wafer 3. For example, the third intra-wafer connection regions 21 are conductive regions based on germanium Ge, or aluminum Al or gold Au or their alloys, for example a gold-tin (Au - Sn) alloy, or based on copper Cu and its alloys, for example Cu-Sn which is soldered with a SLID (Solid Liquid Inter Diffusion) technique and are arranged so as to be aligned with the conductive vias 17 in the cap wafer 2, after bonding the wafers 2, 3, as described in detail below.

Wafers 1-3 may be processed simultaneously or in any order, to obtain the structures depicted in Figure 1 and previously discussed.

In any case, after processing the ASIC wafer 1 and the cap wafer 2 in the manner described above, they are mutually bonded at the second main surface 1B of the ASIC wafer 1 and the first main surface 2A of the cap wafer 2, as shown in Figure 2.

In particular, bonding is performed by bringing the second main surface 1B of the ASIC wafer 1 and the first main surface 2A of the cap wafer 2 into mutual contact, with mutual alignment of the first and second intra-wafer connection regions 12, 16, and using a hybrid bonding process, by applying heat (annealing step), for example at about 400°C for a few tens of minutes, to increase the bonding energy.

Since the second main surface 1B of the ASIC wafer 1 and the first main surface 2A of the cap wafer 2 are perfectly planar, they adhere to each other, melting, and creating a stable bond between the wafers 1, 2 and between the intra-wafer connection regions 12, 16.

In this manner, a first composite wafer 25 is formed, comprising the ASIC wafer 1 and the cap wafer 2, wherein the first intra-wafer connection regions 12, the second intra-wafer connection regions 16 and the conductive vias 17 are in electrical contact with each other. In particular, the first and second intra-wafer connection regions 12, 16 form first intermediate connection regions 22.

This step does not require protection of the ASIC wafer 1 or the use of temporary work wafers (sacrificial wafers), since both the ASIC wafer 1 and the cap wafer 2 have standard thickness; they are therefore robust and may be subject to factory processing on common equipment.

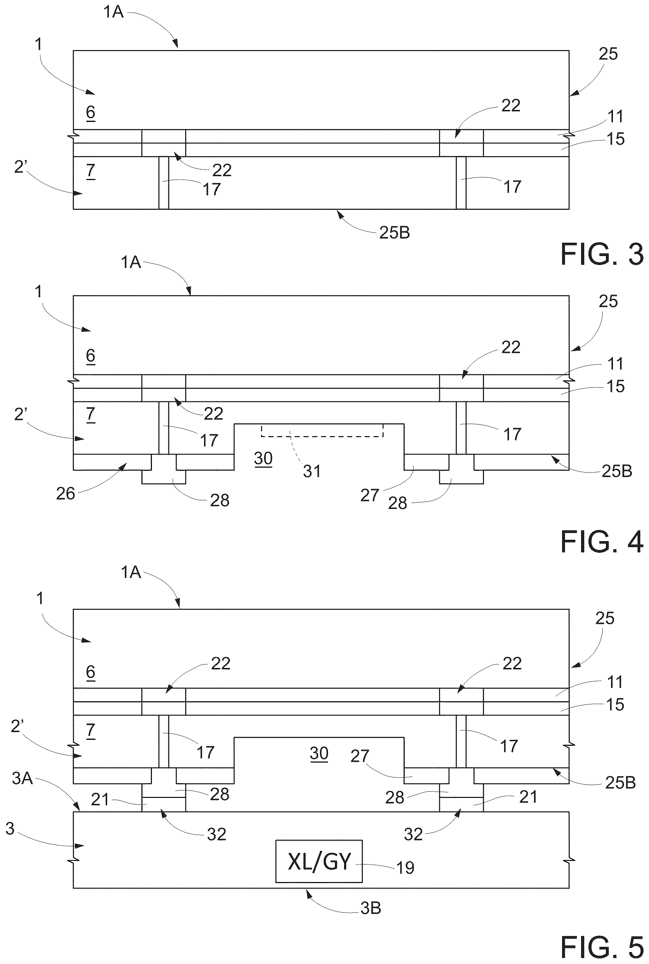

Subsequently, Figure 3, the cap wafer 2 is thinned, for example through lapping until reaching at least the end of the conductive vias 17. For example, the cap wafer 2 is thinned to a thickness of 30-150 µm, for example to a thickness of about 80-100 µm. The thinned cap wafer is indicated in the Figures by 2'.

The conductive vias 17 then become through vias and extend for the entire remaining thickness of the second body 7 (and therefore approximately of the thinned cap wafer 2', since the thickness of the second connection structure 15 is a few microns, for example 3-4 µm at most, and is therefore negligible.

The first thinned composite wafer, indicated by 25' in Figure 3, is then delimited by a first main surface coinciding with the first main surface 1A of the first wafer 1 and therefore indicated again by 1A, and by a second main surface 25B, formed by the thinned cap wafer 2'.

The second main surface 25B of the first thinned composite wafer 25' may also be smoothed by polishing.

In this step, no temporary work structures or wafers are needed, since the desired mechanical robustness of the composite wafer 25 is provided by the secure coupling between the ASIC wafer 1 and the thinned cap wafer 2'.

Subsequently, Figure 4, a fourth connection structure 26 is formed on the second main surface 25B of the first thinned composite wafer 25'.

In particular, an insulating layer (hereinafter referred to as pre-metal layer 27) is formed, for example deposited by plasma. The pre-metal layer 27 is opened at the conductive vias 17 and, in the openings just formed, fourth intra-wafer connection regions 28, typically of metal, are formed; the fourth intra-wafer connection regions 28 may also extend in part above the second main surface 25B of the first thinned composite wafer 25'.

The fourth intra-wafer connection regions 28 are then electrically coupled, in particular they are in direct electrical contact with the conductive vias 17.

Furthermore, the fourth intra-wafer connection regions 28 are arranged so as to be aligned with the third intra-wafer connection regions 21 of the MEMS wafer 3, after mutual bonding of the MEMS wafer 3 and the first thinned composite wafer 25, as explained in detail below.

Furthermore, if desired, cavities and particular surface structures are also formed in the thinned cap wafer 2', at the second main surface 2B. In particular, Figure 4 shows the formation of a cavity 30 that extends through the pre-metal layer 27 and for part of the thickness of the thinned cap wafer 2'. For example, the cavity 30 may be formed so as to be arranged at (facing) the inertial structures 19 (accelerometer XL, gyroscope GY) formed (or to be formed) in the MEMS wafer 3 of Figure 1, as described in detail below.

Typically, the cavities and surface structures 30 are formed after the fourth connection structure 26 has been formed.

Desired structures, for example a getter structure 31, generally used for gyroscopes, may also be formed on the bottom of the cavity 30.

Subsequently, Figure 5, the MEMS wafer 3 (already processed in the manner shown in Figure 1) is bonded to the thinned wafer 2', so that the second main surface 25B of the composite wafer 25 is arranged facing the first main surface 3A of the MEMS wafer 3 and the fourth intra-wafer connection regions 28 are in contact with the third intra-wafer connection regions 21.

For example, the bonding is performed by applying a pressure on the wafers and carrying out an annealing as described above for the bonding of the ASIC wafer 1 to the cap wafer 2.

Since, as indicated above, the third and fourth intra-wafer connection regions 21, 28 are arranged so that they may be aligned, they mutually couple, creating a stable bond between the metal of the fourth intra-wafer connection regions 28 and the material of the third intra-wafer connection regions 21. Second intermediate connection regions 32 are thus formed, Figure 5, and electrically connect the MEMS structures 19 connected thereto in the MEMS wafer 3 to the conductive vias 17 and to the first intermediate connection regions 22.

The composite wafer 25 of Figure 5 therefore has a first main surface formed by the first main surface 1A of the ASIC wafer 1 and a second main surface formed by the second main surface 3B of the MEMS wafer 3.

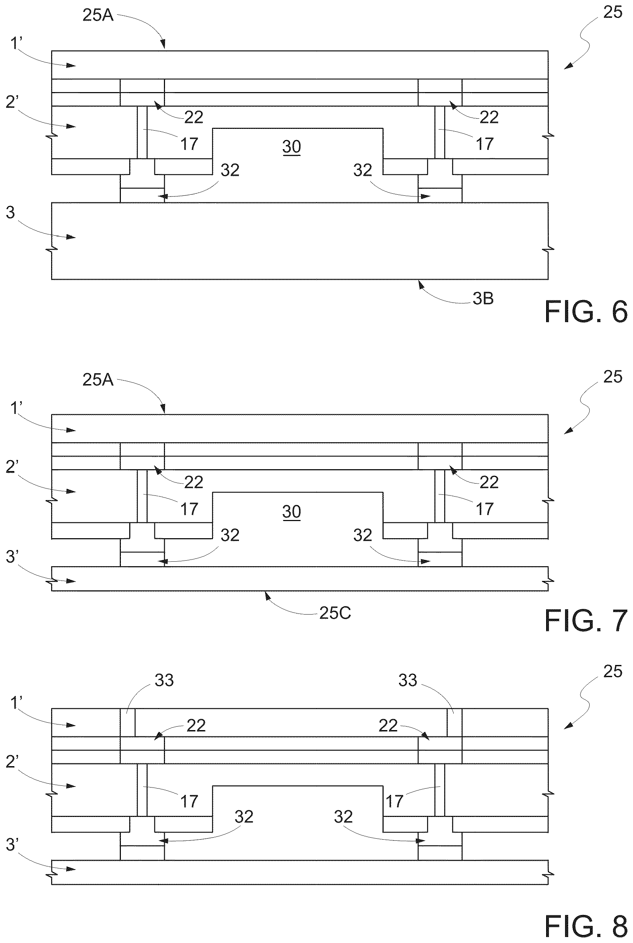

Then, Figure 6, the composite wafer 25 is thinned a first time, reducing the thickness of the ASIC wafer 1. For example, the thinned ASIC wafer, indicated by 1', has a thickness of 50-80 µm.

The composite wafer 25, thinned once, of Figure 6 (hereinafter indicated again by 25, for simplicity) thus has a first main surface 25A, formed by the thinned ASIC wafer 1', and the second main surface 3B.

Then, Figure 7, the once-thinned composite wafer 25 is thinned a second time, reducing the thickness of the MEMS wafer 3 and forming a twice-thinned composite wafer, indicated again by 25. For example, the MEMS wafer 3 is brought to a thickness of 250 µm. The twice-thinned composite wafer is hereinafter indicated again by 25 and the thinned MEMS wafer is hereinafter indicated by 3'.

The twice-thinned composite wafer 25 of Figure 7 thus has the first main surface 25A, formed by the thinned ASIC wafer 1', and a third main surface 25C, formed by the thinned MEMS wafer 3'.

It should be noted that the thinning order shown in Figures 6 and 7 is not essential, and may be reversed, thinning the MEMS wafer 3 first and subsequently the ASIC wafer 1.

Subsequently, Figure 8, the thinned ASIC wafer 1' is subject to processing steps for forming external connection structures.

In detail, external connection vias 33 are formed in the thinned ASIC wafer 1', at the first intra-wafer connection regions 12.

In particular, the external connection vias 33 extend through the entire thickness of the thinned ASIC wafer 1' and extend between the first main surface 25A of the twice-thinned composite wafer 25 and the first intra-wafer connection regions 12, in direct electrical connection therewith.

The external connection vias 33 are formed for example as Through Silicon Vias, TSV, insulated from the rest of the thinned ASIC wafer 1' by respective insulation walls, using a process similar to the process indicated above for the conductive vias 17.

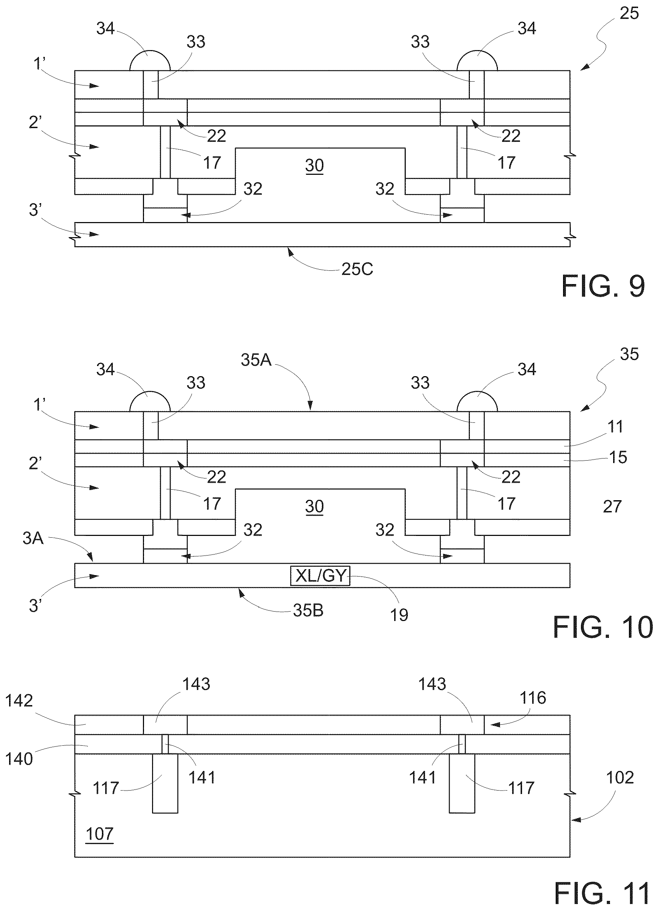

Then, in a manner not shown, a fourth connection structure 34 is formed on the first main surface 25A of the twice-thinned composite wafer 25. For example, an RDL layer (redistribution layer), not shown, is formed on the first main surface 25A; an UBM (Under Bump Metallization) layer, not shown, is formed, and bump regions, for example ball-shaped, are formed, electrically connected to the external connection vias 33, obtaining the final wafer 60 of Figure 9.

The final wafer 60 is then subjected to final assembly steps, including dicing, possible bonding to a supporting structure, such as a leadframe, not shown, and possible packaging, not shown, if desired.

The MEMS device 35 shown in Figure 10 is thus obtained, formed by a first, a second and a third substrate, indicated again by 1', 2', and 3' for ease of understanding, and having a first and a second main surface 35A, 35B, corresponding to the first main surface 25A of the composite wafer 25 and to the third main surface 25C of the composite wafer 25.

The bump regions 34 extend on the first main surface 35A, electrically coupled to the electronic components 10 integrated in the third substrate 3' through the external connection vias 33, the conductive vias 17, the first and second intermediate connection regions 22, 32.

The MEMS device 35 has smaller dimensions compared to similar known devices.

In particular, it has a thickness of 450-480 µm, given by the sum of the thickness of the thinned MEMS wafer 1' (250 µm), the thinned cap wafer 2' (100 µm), the thinned ASIC wafer 3' (50-80 µm) and the bump regions 34 (50 µm), with a thickness reduction of, for example, 46% compared to known MEMS devices.

By shifting the vias to the inside of the device, the area of the pads may be saved, obtaining also a reduction of the footprint (in a plane parallel to the faces 35A, 35B of the MEMS device 35). For example, a footprint reduction of 70% may be obtained compared to known MEMS devices.

This allows the number of MEMS devices 35 that may be formed in the final wafer to be considerably increased.

According to a variant, the conductive vias 17 may be formed by performing a deep silicon etch of the second body 7, leading to forming holes; forming insulating walls in the holes, by depositing a PMD (Pre-Metal Dielectric) insulating layer; and filling the holes by a damascene technique.

According to a different embodiment, the second connection structure 16 of Figure 1 may be formed with a different technique, as shown in Figure 11.

In Figure 11 a second wafer is shown, identified by 102, having a second body 107 wherein conductive vias 117 have already been formed and having the second connection structure, indicated here by 116, extending thereabove.

In detail, in Figure 11, the second connection structure comprises a first dielectric layer 140 having a plurality of plug regions 141 of conductive material, such as a metal, for example tungsten W, aligned and in direct electrical contact with the conductive vias 117.

The plug regions 141 may be obtained by forming holes in the first dielectric layer 140 and filling them with the conductive material.

A second dielectric layer 142 extends above the first dielectric layer 140 and has metal regions 143 aligned and in direct electrical contact with the plug regions 141.

The second dielectric layer 142 may be obtained by depositing insulating material, for example silicon oxide, after forming the plug regions 141.

The metal regions 143 may be formed, for example, by using a damascene technique, like the second intra-wafer connection regions 16 of Figure 1.

This solution, for example, may be useful in the case of a device manufactured using processes that already envisage the two dielectric layers 140, 142.

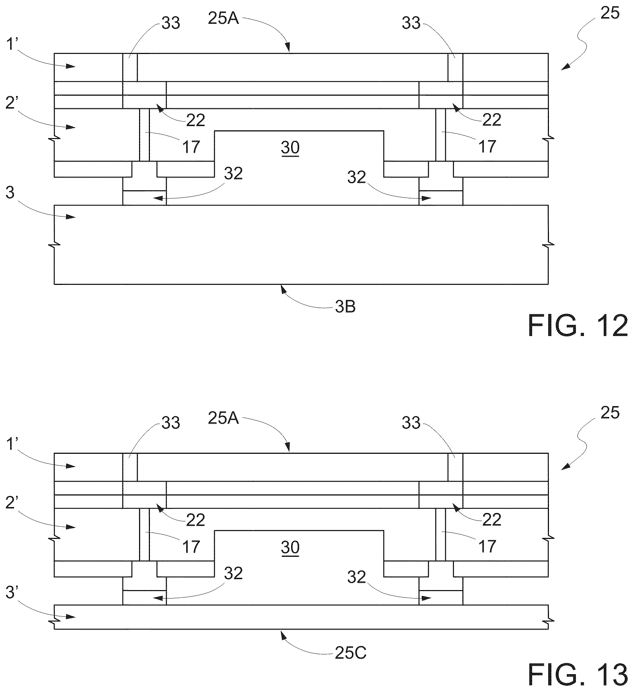

Figures 12 and 13 show a variant of some manufacturing steps of the process of Figures 1-9.

In particular, Figure 12 shows the composite wafer 25 in a manufacturing step subsequent to Figure 6, wherein the external connection vias 33 are formed in the thinned ASIC wafer 1', before thinning the MEMS wafer 3.

In detail, according to Figure 12, before thinning the ASIC wafer 3, the external connection vias 33 are immediately formed in the thinned ASIC wafer 1' in one of the manners discussed above.

Subsequently, Figure 13, MEMS wafer 3 is thinned, forming the thinned MEMS wafer 3'. The same structure of Figure 8 is thus obtained.

This variant then continues with the steps described above with reference to Figures 9 and 10.

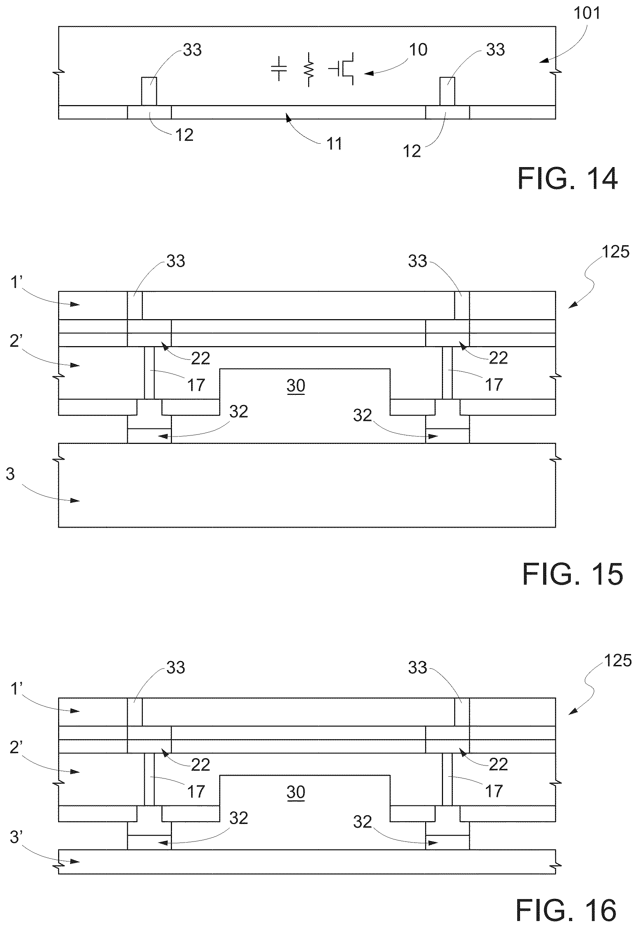

Figure 14 shows an ASIC wafer 101 that may be used, instead of ASIC wafer 1, in the manufacturing process flow shown in Figures 1-7.

In detail, the ASIC wafer 101 of Figure 14 is initially processed to form the external connection vias 33, using for example one of the techniques discussed above for forming the conductive vias 17, "vias first" process.

The external connection vias 33 extend only for a portion of the thickness of the ASIC wafer 101, equal to at least the remaining thickness of the ASIC wafer 101 after thinning.

Subsequently, the electronic circuits 10 are formed, so as to provide the ASIC, and the first connection structure 11 is formed, also here including the first intra-wafer connection regions 12.

The ASIC wafer 101 is then processed as shown in Figures 2-7, therefore, it is bonded to the cap wafer 2; cap wafer 2 is thinned; fourth connection structure 26 is formed; te MEMS wafer 3 is bonded; and ASIC wafer 101 is thinned. In this case, thinning of the ASIC wafer 10 continues until reaching the bottom of the external connection vias 33.

The composite wafer 125 of Figure 15 is thus obtained.

Subsequently, the MEMS wafer 3 is thinned, obtaining the structure shown in Figure 16. The manufacturing steps shown in Figures 9 and 10 then follow.

Finally, it is clear that modifications and variations may be made to the MEMS device and the manufacturing process described and illustrated herein without thereby departing from the scope of the present invention, as defined in the attached claims. For example, the described different embodiments may be combined to provide further solutions.

## Claims

1. A microelectromechanical -MEMS- device (35) comprising:
a first substrate (1'), having a first and a second main face (35A, 1B) and accommodating integrated electrical components (10) and external connection vias (33) extending through the first substrate (1');
a second substrate (2'), having a first and a second main face (2A, 25B) and accommodating conductive vias (17) extending between the first and second main surfaces of the second substrate, the first main face (25B) of the second substrate (2') coupled to the second main face (1B) of the first substrate (1') and the conductive vias (17) coupled to the external connection vias (33); and
a third substrate (3'), having a main face (3A) and accommodating MEMS structures (19), the main face (3A) of the third substrate (3') coupled to the second main face (25B) of the second substrate (2'),
wherein the conductive vias (17) and the external connection vias (33) electrically couple the first face (35A) of the first substrate (1') to the MEMS structures (19).

2. The MEMS device according to claim 1, wherein the second substrate (2') has cavities (30) facing the third substrate (3').

3. The MEMS device according to claim 1 or 2, comprising an external connection structure (34) formed on the first main face (35A) of the first substrate (1') and electrically coupled to the external connection vias (33).

4. The MEMS device according to the preceding claim, wherein the external connection structure (34) comprises ball-shaped bumps.

5. A process for manufacturing a MEMS device (35) according to any of the preceding claims, comprising:
forming electrical components (10) integrated in a first wafer (1) comprising semiconductor material;
forming conductive vias (17) in a second wafer (2) comprising semiconductor material;
forming MEMS structures (19) in a third wafer (3) comprising semiconductor material and having a first and a second main surface (3A, 3B);
mutually coupling the first wafer (1) and the second wafer (2);
thinning the second wafer (2);
mutually coupling the third wafer (3) and the second wafer (2);
thinning the first wafer (1); and
thinning the third wafer (3).

6. The process according to the preceding claim, wherein the first wafer (1), the second wafer (2) and the third wafer (3) have each a first main surface (1A, 2A, 3A) and a second main surface (1B, 2B, 3B) and wherein:
mutually coupling the first wafer (1) and the second wafer (2) comprises coupling the second main surface (1B) of the first wafer (1) to the first main surface (2A) of the second wafer (2), forming a composite wafer (25) having a first and a second main surface (1A, 25B) of the composite wafer formed by the first main surface of the first wafer and, respectively, by the second main surface of the second wafer;
thinning the second wafer (2) comprises thinning the second wafer from the second main surface (2B) of the second wafer, forming a third main surface (25B) of the composite wafer (25) opposite to the first main surface of the composite wafer (25);
mutually coupling the third wafer (3) and the second thinned wafer (2') comprises coupling the third main surface (25B) of the composite wafer (25) to the first main surface (3A) of the third wafer (3);
thinning the first wafer (1) comprises thinning the first wafer from the first main surface (1A) of the first wafer;
thinning the third wafer (3) comprises thinning the third wafer from the second main surface (3B) of the third wafer to obtain a final composite wafer (25), the final composite wafer having a first main surface (25A) formed by the first thinned wafer (1') and a second main surface (25C) formed by the third thinned wafer (3').

7. The process according to the preceding claim, wherein forming conductive vias (17) comprises forming openings extending from the first main surface (2A) of the second wafer (4) and thinning the second wafer (2) comprises partially removing material of the second wafer until the conductive vias (17), wherein the conductive vias (17) extend between the first main surface (1A) and the third main surface (25B) of the composite wafer (25).

8. The process according to claim 6 or 7, further comprising forming cavities (30) in the second wafer (2) from the second main surface (25B) of the composite wafer (25) and wherein coupling the second thinned wafer (2') to the third wafer (3) comprises aligning the cavities (30) with the MEMS structures (19).

9. The process according to any of claims 6-8, further comprising forming external connection vias (33) extending within the first wafer (1) from the second main surface (1B) of the first wafer (1) and aligned with the conductive vias (17) in the second wafer (2).

10. The process according to the preceding claim, further comprising forming external connection structures (34) on the first main surface (25A) of the final composite wafer (25), in electrical contact with the external connection vias (33) and the conductive vias (17).

11. The process according to the preceding claim, wherein the external connection vias (33) are formed after thinning the first wafer (1) and extend between the second main surface (1B) of the first wafer (1) and the first main surface (25A) of the composite wafer (25).

12. The process according to claim 10, wherein the external connection vias (33) are formed prior to coupling the second main surface (1B) of the first wafer (1) to the first main surface (2A) of the second wafer (2), wherein the external connection vias (33) extend from the second main surface (1B) of the first wafer (1) for a thickness portion of the first wafer (1).

13. The process according to any of claims 5-12, wherein the first wafer (1) is thinned prior to the third wafer (3) or vice versa.

14. The process according to any of claims 5-11, wherein the first wafer (1) comprises a first semiconductor body (6) and the second wafer (2) comprises a second semiconductor body (7), the process further comprising, prior to mutually coupling the first wafer (1) and the second wafer (2), forming a first connection structure (11) on the first semiconductor body (6) and forming a second connection structure (15) on the second semiconductor body (7); the first connection structure (11) and the second connection structure (18) comprising each a respective insulating structure (13, 18) and respective intra-wafer connection regions (12, 16), the second intra-wafer connection regions (16) electrically coupled with the conductive vias (17) in the second wafer (2), wherein mutually coupling the first wafer (1) and the second wafer (2) comprises bringing the first and second intra-wafer connection regions (12, 16) into mutual contact and mutually bonding them, preferably with a hybrid bonding process.

15. The manufacturing process according to the preceding claim, wherein forming the first and second intra-wafer connection regions (12, 16) comprises forming metal regions with a damascene process.
